# EUROPÄISCHE PATENTANMELDUNG

(11) **EP 3 648 157 A1**
(43) Veröffentlichungstag der Anmeldung: **06.05.2020**
(21) Anmeldenummer: 18204081.6
(22) Anmeldetag: 02.11.2018
(51) Int. Cl.: H01L 23/373, H01L 23/427

(54) **KÜHLVORRICHTUNG**

(71) Anmelder: Siemens Aktiengesellschaft, 80333 München (DE)
(72) Erfinder: Ochs, Ewgenij, 90765 Fürth (DE); Pfefferlein, Stefan, 90562 Heroldsberg (DE); Bigl, Thomas, 91074 Herzogenaurach (DE); Hensler, Alexander, 90766 Fürth (DE); Neugebauer, Stephan, 91058 Erlangen (DE); Oschmann, Philipp, 91058 Erlangen (DE); Wetzel, Ulrich, 91325 Adelsdorf (DE)

(57) **Zusammenfassung**

Die Erfindung betrifft eine Kühlvorrichtung (1) zur Entwärmung eines elektronischen Bauelements (2), welche ein Wärmerohr (3) und einen Kühlkörper (4) umfasst, wobei der Kühlkörper (4) an einer ersten Kühlkörperseite (5) verlaufend eine Nutaussparung (6) aufweist, welche das Wärmerohr (3) zumindest teilweise umschließt, wobei eine Wärmerohroberfläche (7) des Wärmerohrs (3) im Bereich der Umschließung durch die Nutaussparung (6) eine Faserstruktur (8) aus ersten Fasern (9) aufweist und wobei die ersten Fasern (9) der Wärmerohroberfläche (7) des Wärmerohrs (3) im Bereich der Nutaussparung (6) eine mechanische Verbindung mit einer Kühlkörperoberfläche (10) des Kühlkörpers (4) ausbilden.

## Beschreibung

Die Erfindung betrifft eine Kühlvorrichtung zur Entwärmung eines elektronischen Bauelements, wobei die Kühlvorrichtung ein Wärmerohr und einen Kühlkörper umfasst und der Kühlkörper an einer ersten Kühlkörperseite verlaufend eine Nutaussparung aufweist, welche das Wärmerohr zumindest teilweise umschließt.

In elektrischen Geräten der Antriebstechnik, wie beispielsweise Frequenzumrichtern, werden zur Entwärmung der im Betrieb auftretenden Verlustwärme insbesondere von elektronischen Bauelementen der Leistungselektronik im mittleren und höheren Leistungsbereich Wärmerohre, wie z.B. Heatpipes eingesetzt, wobei ein oder mehrere Wärmerohre die Verlustwärme in oder an beispielsweise einem Aluminiumkühlkörper gleichmäßig von der Wärmequelle weg an kühlere Stellen des Kühlkörpers verteilen und somit effizient abführen.

Die Herstellung einer mechanisch stabilen und thermisch wirksamen Verbindung des Wärmerohres mit dem Kühlkörper ist ein aufwendiger und zeitintensiver Prozess. So steigen die Herstellungskosten eines Kühlkörpers mit einem implementierten Wärmerohr teilweise auf das Doppelte der Herstellung eines Kühlkörpers ohne Wärmerohr. Bei vielen elektrischen Geräten übersteigen diese Herstellungskosten des Kühlkörpers mit Wärmerohr das geplante Budget, mit der Folge, dass die Kühlkörper insbesondere bei erwartet hohen Verlustleistungen eher mit einem größeren Volumen dimensioniert werden. Die Nachteile sind jedoch, dass ein entsprechend größerer Bauraum in den elektrischen Geräten vorgehen werden muss und ein kompakterer Aufbau der elektrischen Geräte schwerer realisierbar ist.

Um Wärmerohre in Kühlkörpern zu implementieren, werden die Wärmerohre in Kontaktflächen des Kühlkörpers derart eingebracht, dass beispielsweise für die Wärmerohre Nuten in den Kühlkörper eingearbeitet, also oftmals eingefräst werden, welche die Form und den Querschnitt des jeweiligen Wärmerohrs abbilden. Bevor das Wärmerohr unter Druck in die entsprechende Kühlkörpernut eingepresst wird, wird ein wärmeleitendes, meist als Klebstoff ausgeführtes Material in Form eines Wärmeleitklebers auf die Kühlkörpernut aufgebracht. Nach Verpressung des Wärmerohrs in die Nut des Kühlkörpers wird der Wärmeleitkleber getrocknet, damit diese wärmeleitende Klebstoffverbindung aushärtet. Anschließen wird die Oberfläche des Kühlkörpers mit dem verpressten Wärmerohr im Allgemeinen noch einmal überfräst, um die Materialunebenheiten und Reste des Wärmeleitklebers abzutragen.

Nachteilig am Wärmeleitkleber ist seine - im Gegensatz beispielsweise zu Metallverbindungen aus Kupfer und/oder aus Aluminium - wesentlich schlechtere Wärmeleitfähigkeit, welche jedoch besser ist als beispielsweise die von teilweise in Verpressungshohlräumen auftretender eingeschlossener Luft. Derartige thermische Barrieren für einen Wärmetransport werden durch den Wärmeleitkleber zumindest verringert.

Ein weiterer entscheidender Nachteil ist, dass nach oftmals kurzen Betriebszeiten der zwischen Kühlkörper und Wärmerohr eingebrachte Wärmeleitkleber verklumpen oder spröde werden kann. Der thermische Widerstand des Kühlkörpers wird dann zum Teil erheblich ansteigen und den Betrieb des zu entwärmenden elektronischen Bauteils in dem elektrischen Gerät gefährden bzw. das elektronische Bauteil und somit ggf. das gesamte elektrische Gerät zerstören.

Der Erfindung liegt daher die Aufgabe zugrunde, eine Kühlvorrichtung mit einem Wärmerohr und einem Kühlkörpern bereitzustellen, deren mechanisch/thermische Verbindung gegenüber dem Stand der Technik verbessert ist.

Die Aufgabe wird durch eine Kühlvorrichtung mit den in Anspruch 1 angegebenen Merkmalen sowie durch einen Umrichter mit der Kühlvorrichtung nach den in Anspruch 13 angegebenen Merkmalen gelöst.

Für die Lösung der Aufgabe wird eine Kühlvorrichtung vorgeschlagen, welche zur Entwärmung eines elektronischen Bauelements ein Wärmerohr und einen Kühlkörper umfasst, wobei der Kühlkörper an einer ersten Kühlkörperseite verlaufend eine Nutaussparung aufweist, welche das Wärmerohr zumindest teilweise umschließt, wobei eine Wärmerohroberfläche des Wärmerohrs im Bereich der Umschließung durch die Nutaussparung eine Faserstruktur aus ersten Fasern aufweist und wobei die ersten Fasern der Wärmerohroberfläche des Wärmerohrs im Bereich der Nutaussparung eine mechanische Verbindung mit einer Kühlkörperoberfläche des Kühlkörpers ausbilden.

Durch die vorteilhafte Verwendung der ersten Fasern der Faserstruktur des Wärmerohrs, welche insbesondere ein Material wie das des Wärmerohrs aufweisen, wurden Spalten, welche bei einer Verpressung des Wärmerohrs in die Nutaussparung des Kühlkörpers im Allgemeinen im mikroskopischen Bereich entstehen können, aufgefüllt und somit überbrückt. Die während der Verpressung ausgeübte Druckkraft hat im Allgemeinen bewirkt, dass mittels der metallischen ersten Fasern die Wärmerohroberfläche des Wärmerohres mit der metallischen Kühlkörperoberfläche des Kühlkörpers in einer stoffschlüssigen unlösbaren oder zumindest eingeschränkt lösbare Verbindung verbunden ist. Die ersten Fasern sind dabei Bestandteil der Wärmerohroberfläche des Wärmerohrs.

Somit kann auf den Einsatz eines Wärmeleitklebers für die mechanisch/thermischen Verbindung zwischen Wärmerohr und Kühlkörper in vorteilhafter Weise verzichtet werden, so dass das bekannte Verklumpen und spröde werden von Wärmeleitklebern keinen negativen Einfluss mehr auf den thermischen Widerstandswert der thermischen Verbindung zwischen Wärmerohr und Kühlkörper hat und hier auch eine mechanisch stabilere metallische Verbindung ausgeführt ist.

Vorteilhafte Ausgestaltungsformen des modularen Umrichters sind in den abhängigen Ansprüchen angegeben.

Bei einer ersten vorteilhaften Ausgestaltungsform der Kühlvorrichtung weist die erste Kühlkörperoberfläche im Bereich der Nutaussparung eine weitere Faserstruktur aus zweiten Fasern auf und bilden die ersten Fasern der Wärmerohroberfläche des Wärmerohrs im Bereich der Nutaussparung eine mechanische Verbindung mit den zweiten Fasern der Kühlkörperoberfläche des Kühlkörpers aus.

Die Faserstruktur und die weitere Faserstruktur weisen jeweils mittels der ersten und zweiten Fasern eine bürstenähnliche Geometrie auf. Durch eine Verschlingung bzw. eine Verfilzung der ersten Fasern der Wärmerohroberfläche des Wärmerohrs mit den zweiten Fasern der Kühlkörperoberfläche des Kühlkörpers hat sich eine vorteilhaft mechanische wie auch thermische Verbindung der Wärmerohroberfläche mit der Kühlkörperoberfläche und somit des Wärmerohres mit dem Kühlkörper ausgebildet. Dies stärkt insbesondere die stoffschlüssige mechanische Verbindung des Wärmerohrs mit dem Kühlkörper und verbessert weiter deren thermische Kopplung.

Die zweiten Fasern sind, soweit vorhanden, Bestandteil der Kühlkörperoberfläche des Kühlkörpers.

Bei einer weiteren vorteilhaften Ausgestaltungsform der Kühlvorrichtung sind die zweiten Fasern, welche an den Nutränder der Nutaussparung angeordnet sind, länger, als die zweiten Fasern, welche am Nutgrund der Nutaussparung angeordnet sind.

Diese Ausgestaltungsform berücksichtigt in vorteilhafter Weise, dass die Kraftausübung bei der Verpressung des Wärmerohrs mit dem Kühlkörper ihre Kraftwirkung hauptsächlich in Richtung Nutgrund ausübt. Damit ist die mechanisch/thermische Verbindung der längeren zweiten Fasern an den Nuträndern mit den dort angeordneten ersten Fasern zumindest gleichwertig bzgl. mechanischer Stabilität und thermischem Widerstandswert, wie die mechanisch/thermische Verbindung der kürzeren zweiten Fasern am Nutgrund mit den dort angeordneten ersten Fasern.

Bei einer ebenfalls vorteilhaften Ausgestaltungsform der Kühlvorrichtung weist die erste Kühlkörperoberfläche im Bereich der Nutaussparung eine aufgeraute Oberflächenstruktur auf und bilden die ersten Fasern der Wärmerohroberfläche des Wärmerohrs eine mechanische Verbindung mit der aufgerauten Oberflächenstruktur der Kühlkörperoberfläche des Kühlkörpers im Bereich der Nutaussparung aus.

Die ersten Fasern der Wärmerohroberfläche des Wärmerohrs umschlingen die aufgeraute Oberflächenstruktur bzw. verkeilen sich zwischen der aufgerauten Oberflächenstruktur der Kühlkörperoberfläche des Kühlkörpers und bilden eine vorteilhafte mechanische wie auch thermische Verbindung der Wärmerohroberfläche mit der Kühlkörperoberfläche und somit des Wärmerohres mit dem Kühlkörper.

Bei einer weiteren vorteilhaften Ausgestaltungsform der Kühlvorrichtung durchdringen die ersten Fasern der Wärmerohroberfläche des Wärmerohrs die Kühlkörperoberfläche des Kühlkörpers im Bereich der Nutaussparung.

Die ersten Fasern der Wärmerohroberfläche des Wärmerohrs dringen derart in die Kühlkörperoberfläche des Kühlkörpers ein, dass sie sich in vorteilhafter Weise insbesondere mechanisch stoffschlüssig mit der Kühlkörperoberfläche verbinden. Sie können darüber hinaus auch tiefer in die Grundstruktur des Kühlkörpers eindringen, was die mechanische und somit auch die thermische Verbindung des Wärmerohres mit dem Kühlkörper weiter verbessert.

Bei einer ebenfalls vorteilhaften Ausgestaltungsform der Kühlvorrichtung weisen die ersten Fasern der Faserstruktur und, falls vorhanden, die zweiten Fasern der weiteren Faserstruktur oder die aufgeraute Oberflächenstruktur eine nanoskalige oder mikroskalige Struktur auf.

Mittels dieser nanoskaligen oder mikroskaligen Struktur der ersten Fasern der Faserstruktur und, falls vorhanden, der zweiten Fasern der weiteren Faserstruktur sind Verpressungshohlräume mit z.B. Lufteinschlüssen, welche aufgrund der Verpressung des Wärmerohres in den Kühlkörper entstehen könnten, in vorteilhafter Weise mit metallischem Material der Fasern feingranular aufgefüllt, so dass insbesondere der thermische Widerstand der thermischen Verbindung des Wärmerohres mit dem Kühlkörper gegenüber der Einbringung eines Wärmeleitklebers weiter verbessert wird. Unter nanoskaligen oder mikroskaligen Strukturen werden Abmessungen von Körpern bzw. Strukturen verstanden, welche in einem nanoskaligen Bereich von Nanometern oder in einem mikroskaligen Bereich von Mikrometern nur unter starker Vergrößerung für das menschliche Auge sichtbar werden.

Bei einer weiteren vorteilhaften Ausgestaltungsform der Kühlvorrichtung weisen die ersten Fasern Widerhaken und, falls vorhanden, die zweiten Fasern Ösen auf.

Mittels der Widerhaken ist eine mechanische Verbindung der ersten Fasern mit der Kühlkörperoberfläche hergestellt, welche kaum noch zerstörungsfrei trennbar ist. Falls die zweiten Fasern an der Kühlkörperoberfläche vorhanden sind, bilden die Widerhaken und die Ösen, in welchen die Widerhaken verankert sind, eine verbesserte, stabilere mechanische Verbindung. Unter Ösen werden auch Öffnungen in den zweiten Fasern verstanden, welche bei der Verpressung des Wärmerohres in den Kühlkörper unter Durchstoßen von Widerhaken durch die zweiten Fasern ausgebildet sind. Verbindungen, welche Fasern mit Widerhaken und Ösen aufweisen, werden auch als Klettverschlüsse bezeichnet.

Bei einer ebenfalls vorteilhaften Ausgestaltungsform der Kühlvorrichtung sind die ersten Fasern und, falls vorhanden, die zweiten Fasern durch Materialbeschichtung oder durch Materialabtrag ausgebildet.

Sind die ersten Fasern und, falls vorhanden, die zweiten Fasern durch Materialbeschichtung ausgebildet, kann deren Material von dem Material des Wärmerohres bzw. des Kühlköpers abweichen. Vorteilhaft ist hier die Abweichung des Materials der zweiten Fasern der Kühlkörperoberfläche vom Material des Kühlkörpers, also vom Material der Grundstruktur des Kühlkörpers. Der Kühlkörper kann dazu aus Aluminium oder aus einer Aluminiumlegierung bestehen, während die Kühlkörperoberfläche mit den zweiten Fasern beispielsweise aus Kupfer oder einer Kupferlegierung besteht. Sind die ersten Fasern der Wärmerohroberfläche des Wärmerohrs dann beispielsweise ebenfalls aus Kupfer, ist eine sehr gute mechanisch stoffschlüssige Verbindung mit einer sehr guten thermischen Wärmeleitfähigkeit ausgebildet.

Bei einer weiteren vorteilhaften Ausgestaltungsform der Kühlvorrichtung bestehen die ersten Fasern der Wärmerohroberfläche des Wärmerohrs und, falls vorhanden, die zweiten Fasern der Kühlkörperoberfläche des Kühlkörpers aus Kupfer oder aus einer Kupferlegierung.

Das Kupfer bzw. die Kupferlegierung ist für die thermische Verbindung der ersten Fasern der Wärmerohroberfläche des Wärmerohrs mit der Kühlkörperoberfläche des Kühlkörpers und, falls vorhanden, mit den zweiten Fasern der Kühlkörperoberfläche des Kühlkörpers ein gut geeignetes Material, da hier der thermische Widerstand dieser mechanisch/thermischen Verbindung vorteilhaft reduziert ist gegenüber beispielsweise einer Verbindung unter Einsatz eines Wärmeleitklebers oder gegenüber beispielsweise einer Verbindung bestehend aus Aluminium und Kupfer.

Bei einer ebenfalls vorteilhaften Ausgestaltungsform der Kühlvorrichtung ist das Material der ersten Fasern des Wärmerohrs mechanisch härter als das Material der Kühlkörperoberfläche des Kühlkörpers.

Da das Material der ersten Fasern in vorteilhafter Weise härter ist, als das Material der Kühlkörperoberfläche des Kühlkörpers, ist die Kühlkörperoberfläche intensiv von den ersten Fasern durchdrungen, was die Stabilität der mechanischen Verbindung erhöht, insbesondere auch dann, wenn die ersten Fasern über Widerhaken verfügen. Ferner können die ersten Fasern noch besser über die Kühlkörperoberfläche in die Grundstruktur des Kühlkörper eindringen.

Bei einer weiteren vorteilhaften Ausgestaltungsform der Kühlvorrichtung ist das Wärmerohr eine Heatpipe.

Die Nutzung einer Heatpipe als Wärmerohr in der Kühlvorrichtung hat den Vorteil, dass Heatpipes sowohl in horizontaler wie auch in vertikaler Einbaulage eingesetzt werden können, im Gegensatz zu Zwei-Phasen-Thermosiphons, welche schwerkraftgetrieben sind. Ferner sind die Bezugskosten von Heatpipes auch für die Entwärmung von elektronischen Bauelementen höherer Leistungsklassen eher gering, da sie als Massenartikel hergestellt werden, wobei die Kühlvorrichtung dann ebenfalls preisgünstig angeboten werden kann.

Bei einer ebenfalls vorteilhaften Ausgestaltungsform der Kühlvorrichtung weist der Kühlkörper an einer von der ersten Kühlkörperseite abgewandten zweiten Kühlkörperseite Kühlkörperrippen auf.

Die Kühlkörperrippen am Kühlkörper unterstützen in Kombination mit dem Wärmerohr die Entwärmung von elektronischen Bauelementen im Betrieb, indem deren Verlustwärme in vorteilhafter Weise an die Umgebung abgegeben werden kann.

Für die Lösung der Aufgabe wird ferner ein Umrichter zum Betrieb einer elektrischen Maschine an einem elektrischen Netz mit der erfindungsgemäßen Kühlvorrichtung und einem elektronischen Bauelement vorgeschlagen, wobei das elektronische Bauelement mit einem Kühlkörper der Kühlvorrichtung im Bereich eines von dem Kühlkörper zumindest teilweise umschlossenen Wärmerohrs der Kühlvorrichtung mechanisch verbunden ist.

Im Betrieb des Umrichters bzw. beim Betrieb des elektronischen Bauelements wird die dort erzeugte Verlustwärme in vorteilhafter Weise mittels des in den Kühlkörper integrierten Wärmerohrs von dem elektronischen Bauelement weggeleitet und von dem Kühlkörper an die Umgebung abgegeben.

Bei einer vorteilhaften Ausgestaltungsform des Umrichters ist der Kühlkörper als ein Umrichtergehäuse oder als ein Teil eines Umrichtergehäuses ausgebildet.

Die Kühlvorrichtung, also der Kühlkörper mit dem integrierten Wärmerohr, kann hier aus Sicht der räumlichen Anordnung und Ausdehnung in vorteilhafter Weise für den Umrichter angeordnet werden, wobei vorhandene oder erforderliche bauliche Strukturen des Umrichters, also das Umrichtergehäuses benutzt werden.

Bei einer weiteren vorteilhaften Ausgestaltungsform des Umrichters ist das elektronische Bauelement ein Leistungshalbleiter oder ein Leistungshalbleitermodul.

So kann das Leistungshalbleitermodul eine Vielzahl von Leistungshalbleitern aufweisen, welche im Betrieb des Umrichters bzw. des Leistungshalbleitermoduls mittels der Kühlvorrichtung entwärmt werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Es zeigt:
- FIG 1: eine schematische Darstellung einer Metallfaserstruktur auf einer Oberfläche eines Metallkörpers,
- FIG 2: eine erste schematische Schnittdarstellung einer erfindungsgemäßen Kühlvorrichtung mit ersten Fasern einer Faserstruktur und zweiten Fasern einer weiteren Faserstruktur,
- FIG 3: eine zweite schematische Schnittdarstellung einer erfindungsgemäßen Kühlvorrichtung mit ersten Fasern einer Faserstruktur und zweiten Fasern einer weiteren Faserstruktur,
- FIG 4: eine dritte schematische Schnittdarstellung einer erfindungsgemäßen Kühlvorrichtung mit einer aufgerauten Oberflächenstruktur einer Kühlkörperoberfläche eines Kühlkörpers,
- FIG 5: eine vierte schematische Schnittdarstellung einer erfindungsgemäßen Kühlvorrichtung mit eine Kühlkörperoberfläche eines Kühlkörpers durchdringenden ersten Fasern,
- FIG 6: eine fünfte schematische Schnittdarstellung einer erfindungsgemäßen Kühlvorrichtung mit einer Anbindung eines elektronischen Bauelements an die Kühlvorrichtung,
- FIG 7: eine schematische Darstellung der Draufsicht auf die erfindungsgemäße Kühlvorrichtung nach FIG 6 und
- FIG 8: eine schematische Darstellung eines Umrichters mit der erfindungsgemäßen Kühlvorrichtung nach den Figuren 2 bis 7.

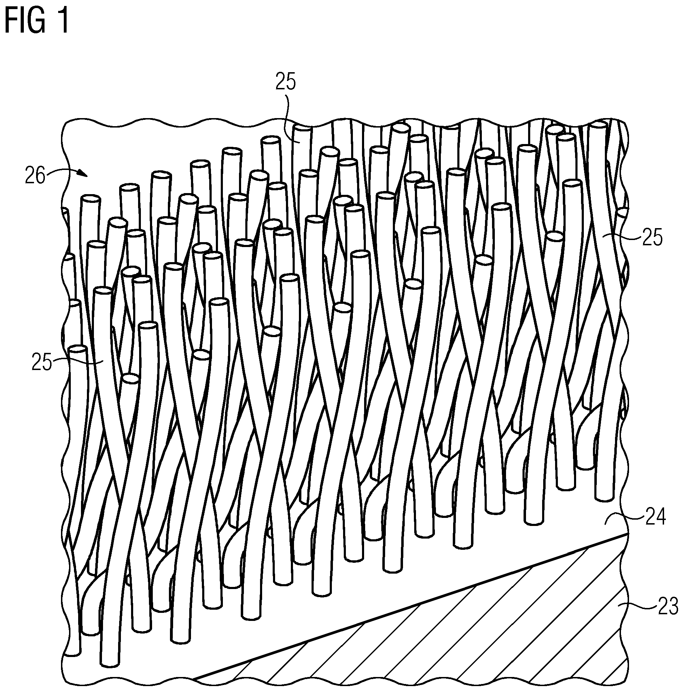

Die FIG 1 zeigt eine schematische Darstellung einer Metallfaserstruktur 26 auf einer Oberfläche 24 eines Metallkörpers 23. Die Metallfaserstruktur 26 weist dabei Metallfasern 25 auf, welche im Wesentlichen senkrecht von der Oberfläche 24 des Metallkörpers 23 abstehen. Die schematische Darstellung der FIG 1 ist dabei stark vergrößert, da hier die Metallfasern 25 der Metallfaserstruktur 26 im nanoskaligen oder mikroskaligen Bereich ausgebildet sind.

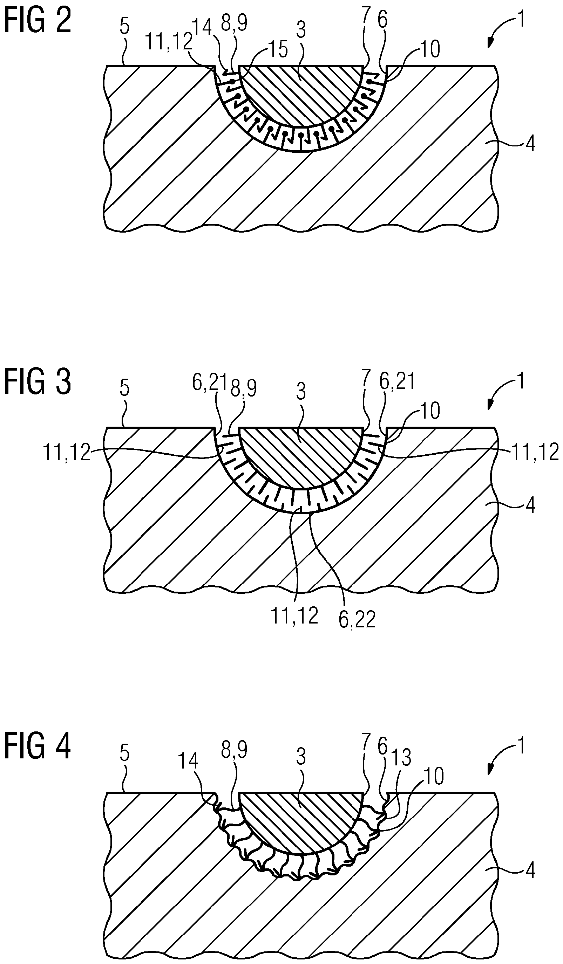

Alle im folgenden beschriebenen Figuren 2 bis 7 sind in ihrer schematischen Darstellung stark vergrößert und zeigen eine Kühlvorrichtung 1 in einem insbesondere nanoskaligen oder mikroskaligen Bereich mit einer mechanischen/thermischen Verbindung eines Wärmerohres 2 mit einem Kühlkörper 4.

In FIG 2 wird eine erste schematische Schnittdarstellung einer erfindungsgemäßen Kühlvorrichtung 1 mit ersten Fasern 9 einer Faserstruktur 8 und zweiten Fasern 12 einer weiteren Faserstruktur 11 aufgezeigt.

Ein Wärmerohr 3 der Kühlvorrichtung 1 ist mit einem Kühlkörper 4 der Kühlvorrichtung 1 über die ersten Fasern 9 der Faserstruktur 8 an der Wärmerohroberfläche 7 des Wärmerohres 3 und die zweiten Fasern 12 der weiteren Faserstruktur 11 an der Kühlkörperoberfläche 10 des Kühlkörpers 4 mechanisch verbunden. Das Wärmerohr 3 wird dabei von einer Nutaussparung 6, welche an einer ersten Kühlkörperseite 5 des Kühlkörpers 4 angeordnet ist, teilweise umschlossen, wobei die ersten und die zweiten Fasern 9,12 im Bereich der Umschließung angeordnet sind. Die mechanische Verbindung ist im Wesentlichen eine stoffschlüssige Verbindung (hier stark vergrößert dargestellt). Das Wärmerohr 3 und der Kühlkörper 4 bilden an der ersten Kühlkörperseite 5 des Kühlkörpers 4 eine plane Fläche aus.

Die ersten Fasern 9 weisen ferner Widerhaken 14 und die zweiten Fasern 12 Ösen 15 auf, wobei sich die Widerhaken 14 der ersten Fasern 9 mit den Ösen 15 der zweiten Fasern 12 mechanisch verbinden (hier nur andeutungsweise in FIG 2 visualisiert). Diese Verbindung ist mechanisch sehr stabil und kann als Klettverschlussverbindung bezeichnet werden.

Mit der FIG 3 wird eine zweite schematische Schnittdarstellung einer erfindungsgemäßen Kühlvorrichtung 1 mit ersten Fasern 9 einer Faserstruktur 8 und zweiten Fasern 12 einer weiteren Faserstruktur 11 aufgezeigt.

Ein Wärmerohr 3 der Kühlvorrichtung 1 ist mit einem Kühlkörper 4 der Kühlvorrichtung 1 über die ersten Fasern 9 der Faserstruktur 8 an der Wärmerohroberfläche 7 des Wärmerohres 3 und die zweiten Fasern 12 der weiteren Faserstruktur 11 an der Kühlkörperoberfläche 10 des Kühlkörpers 4 mechanisch verbunden. Das Wärmerohr 3 wird dabei von einer Nutaussparung 6, welche an einer ersten Kühlkörperseite 5 des Kühlkörpers 4 angeordnet ist, teilweise umschlossen, wobei die ersten und die zweiten Fasern 9,12 im Bereich der Umschließung angeordnet sind. Die mechanische Verbindung ist im Wesentlichen eine stoffschlüssige Verbindung (hier stark vergrößert dargestellt). Das Wärmerohr 3 und der Kühlkörper 4 bilden an der ersten Kühlkörperseite 5 eine plane Fläche aus.

Die mechanische Verbindung des Wärmerohrs 3 mit dem Kühlkörper 4 erfolgte hier mittels Verpressung des Wärmerohrs 3 in den Kühlkörper 4 an dessen erster Kühlkörperseite 5, wobei die Kraftausübung bei der Verpressung ihre Kraftwirkung hauptsächlich in Richtung des Nutgrunds 22 der Nutaussparung 6 ausübt.

In FIG 3 ist das Ergebnis der Verpressung in Form einer effizienten mechanisch/thermischen Verbindung des Wärmerohres 3 mit dem Kühlkörper 4 dargestellt, wobei die Verbindung der längeren zweiten Fasern 12 an den Nuträndern 21 der Nutaussparung 6 mit den dort angeordneten ersten Fasern 9 zumindest gleichwertig bzgl. der mechanischen Stabilität und des thermischem Widerstandswert ist, wie die Verbindung der kürzeren zweiten Fasern 12 am Nutgrund 22 der Nutaussparung 6 mit den dort angeordneten ersten Fasern 9.

Die FIG 4 zeigt eine dritte schematische Schnittdarstellung einer erfindungsgemäßen Kühlvorrichtung 1 mit einer aufgerauten Oberflächenstruktur 13 einer Kühlkörperoberfläche 10 eines Kühlkörpers 4.

Ein Wärmerohr 3 der Kühlvorrichtung 1 ist mit einem Kühlkörper 4 der Kühlvorrichtung 1 über die ersten Fasern 9 der Faserstruktur 8 an der Wärmerohroberfläche 7 des Wärmerohres 3 und die aufgeraute Oberflächenstruktur 13 der Kühlkörperoberfläche 10 des Kühlkörpers 4 mechanisch verbunden. Das Wärmerohr 3 wird dabei von einer Nutaussparung 6, welche an einer ersten Kühlkörperseite 5 des Kühlkörpers 4 angeordnet ist, teilweise umschlossen, wobei die ersten Fasern 9 und die aufgeraute Oberflächenstruktur 13 im Bereich der Umschließung angeordnet sind. Die mechanische Verbindung ist im Wesentlichen eine stoffschlüssige Verbindung (hier stark vergrößert dargestellt). Das Wärmerohr 3 und der Kühlkörper 4 bilden an der ersten Kühlkörperseite 5 eine plane Fläche aus.

Die ersten Fasern 9 der Wärmerohroberfläche 7 des Wärmerohrs 3 weisen Widerhaken 14 auf, welche die Umschließung bzw. die Verkeilung der aufgerauten Oberflächenstruktur 13 der Kühlkörperoberfläche 10 des Kühlkörpers 4 weiter verbessern.

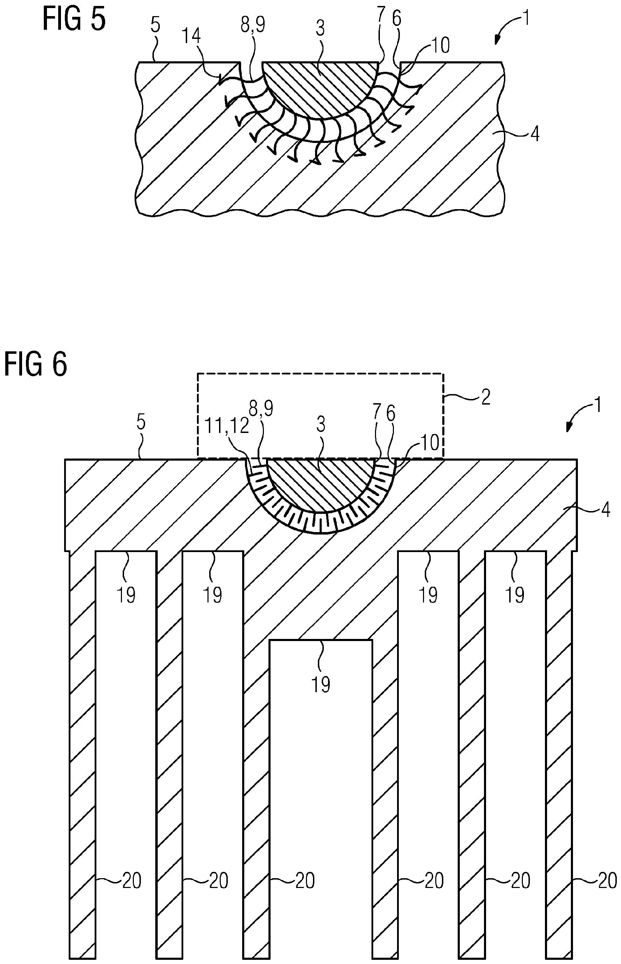

Eine vierte schematische Schnittdarstellung in der FIG 5 visualisiert eine erfindungsgemäße Kühlvorrichtung 1 mit eine Kühlkörperoberfläche 10 eines Kühlkörpers 4 durchdringenden ersten Fasern 9.

Ein Wärmerohr 3 der Kühlvorrichtung 1 ist mit einem Kühlkörper 4 der Kühlvorrichtung 1 über die ersten Fasern 9 der Faserstruktur 8 an der Wärmerohroberfläche 7 des Wärmerohres 3, welche die Kühlkörperoberfläche 10 des Kühlkörpers 4 durchdringen, mechanisch verbunden. Das Wärmerohr 3 wird dabei von einer Nutaussparung 6, welche an einer ersten Kühlkörperseite 5 des Kühlkörpers 4 angeordnet ist, teilweise umschlossen, wobei die ersten Fasern 9 im Bereich der Umschließung angeordnet sind. Die mechanische Verbindung ist im Wesentlichen eine stoffschlüssige Verbindung (hier stark vergrößert dargestellt). Das Wärmerohr 3 und der Kühlkörper 4 bilden an der ersten Kühlkörperseite 5 eine plane Fläche aus.

Die ersten Fasern 9 der Wärmerohroberfläche 7 des Wärmerohrs 3 weisen Widerhaken 14 auf, welche zumindest in der Kühlkörperoberfläche 10 des Kühlkörpers 4 verhakt sind. In der FIG 5 ist darüber hinaus dargestellt, dass die ersten Fasern 9 tiefer in die Grundstruktur des Kühlkörpers 4 eindringen und dort verhakt sind.

In der FIG 6 wird eine fünfte schematische Schnittdarstellung einer erfindungsgemäßen Kühlvorrichtung 1 mit einer Anbindung eines elektronischen Bauelements 2 an die Kühlvorrichtung 1 dargestellt.

Ein Wärmerohr 3 der Kühlvorrichtung 1 ist mit einem Kühlkörper 4 der Kühlvorrichtung 1 über die ersten Fasern 9 der Faserstruktur 8 an der Wärmerohroberfläche 7 des Wärmerohres 3 und die zweiten Fasern 12 der weiteren Faserstruktur 11 an der Kühlkörperoberfläche 10 des Kühlkörpers 4 mechanisch verbunden. Das Wärmerohr 3 wird dabei von einer Nutaussparung 6, welche an einer ersten Kühlkörperseite 5 des Kühlkörpers 4 angeordnet ist, teilweise umschlossen, wobei die ersten und die zweiten Fasern 9,12 sind im Bereich der Umschließung angeordnet sind. Die mechanische Verbindung ist im Wesentlichen eine stoffschlüssige Verbindung (hier stark vergrößert dargestellt). Das Wärmerohr 3 und der Kühlkörper 4 bilden an der ersten Kühlkörperseite 5 eine plane Fläche aus.

An der planen Fläche der ersten Kühlkörperseite 5 ist das elektronische Bauelement 2 über dem Wärmerohr 3 derart anordnet, damit es im Betrieb mittels des Wärmerohrs 3 und des Kühlkörpers 4 entwärmbar ist.

Der Kühlkörper 4 weist an einer von der ersten Kühlkörperseite 5 abgewandten zweiten Kühlkörperseite 19 Kühlkörperrippen 20 auf. Diese Kühlkörperrippen 20 des Kühlkörpers 4 unterstützen im Betrieb die Entwärmung des elektronischen Bauelements 2 in Kombination mit dem Wärmerohr 3, indem sie die Verlustwärme des elektronischen Bauelements 2 in vorteilhafter Weise an die Umgebung abgegeben.

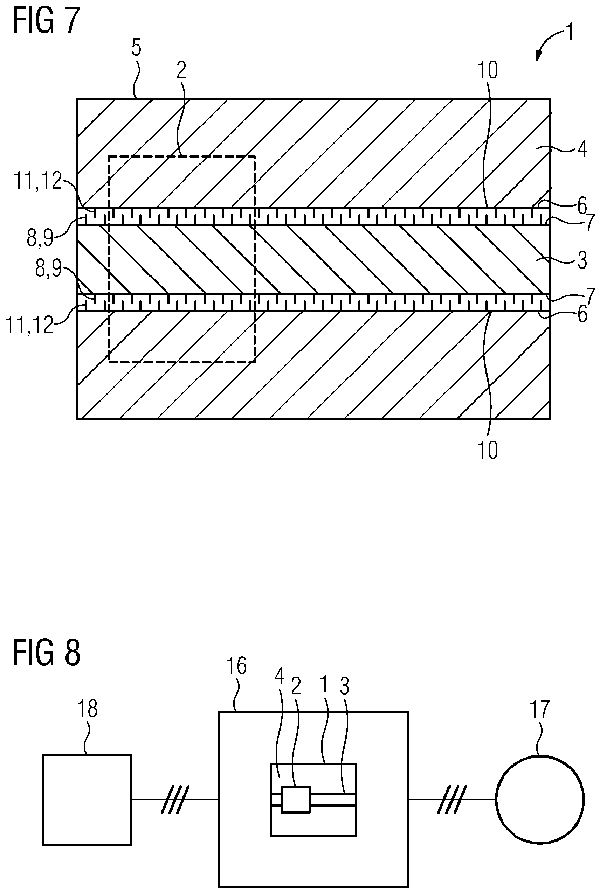

Die FIG 7 zeigt in einer schematischen Darstellung eine Draufsicht auf die erfindungsgemäße Kühlvorrichtung 1 nach FIG 6.

Der FIG 7 sind jedoch die in FIG 6 gezeigten Kühlkörperrippen nicht zu entnehmen, da die von der ersten Kühlkörperseite 5 abgewandte zweite Kühlkörperseite mit den dort angeordneten Kühlkörperrippen aus Gründen der Übersichtlichkeit nicht dargestellt werden.

In FIG 8 zeigt in einer schematischen Darstellung einen Umrichter 16 mit der erfindungsgemäßen Kühlvorrichtung 1 nach den Figuren 2 bis 7.

Der Umrichter 16 ist hier beispielhaft über jeweils dreiphasige elektrische Drehstromleitungen mit einem elektrischen Netz 18 und einer elektrischen Maschine 17 verbunden, wobei der Umrichter 16 im Betrieb die elektrische Maschine 17 im Allgemeinen moment- und drehzahlabhängig mit elektrischer Energie aus dem elektrischen Netz 18 versorgt.

Das elektronische Bauelement 2 ist an einem Kühlkörper 4 und einem in den Kühlkörper 4 integrierten Wärmerohr 3 der Kühlvorrichtung 1 angeordnet. Die im Betrieb von dem elektronischen Bauelement 2 erzeugte Verlustwärme ist dann mittels des Wärmerohrs 3 an kühlere Bereiche des Kühlkörpers 4 leitbar und hauptsächlich über den Kühlkörper 4 an die Umgebung innerhalb oder außerhalb des Umrichters 16 abgebbar.

## Patentansprüche

1. Kühlvorrichtung (1) zur Entwärmung eines elektronischen Bauelements (2), umfassend ein Wärmerohr (3) und einen Kühlkörper (4), wobei
- der Kühlkörper (4) an einer ersten Kühlkörperseite (5) verlaufend eine Nutaussparung (6) aufweist, welche das Wärmerohr (3) zumindest teilweise umschließt,
- eine Wärmerohroberfläche (7) des Wärmerohrs (3) im Bereich der Umschließung durch die Nutaussparung (6) eine Faserstruktur (8) aus ersten Fasern (9) aufweist und
- die ersten Fasern (9) der Wärmerohroberfläche (7) des Wärmerohrs (3) im Bereich der Nutaussparung (6) eine mechanische Verbindung mit einer Kühlkörperoberfläche (10) des Kühlkörpers (4) ausbilden.

2. Kühlvorrichtung (1) nach Anspruch 1, wobei die erste Kühlkörperoberfläche (10) im Bereich der Nutaussparung (6) eine weitere Faserstruktur (11) aus zweiten Fasern (12) aufweist und die ersten Fasern (9) der Wärmerohroberfläche (7) des Wärmerohrs (3) im Bereich der Nutaussparung (6) eine mechanische Verbindung mit den zweiten Fasern (12) der Kühlkörperoberfläche (10) des Kühlkörpers (4) ausbilden.

3. Kühlvorrichtung (1) nach Anspruch 2, wobei die zweiten Fasern (12), welche an den Nutränder (21) der Nutaussparung (6) angeordnet sind, länger sind, als die zweiten Fasern (12), welche am Nutgrund (22) der Nutaussparung (6) angeordnet sind.

4. Kühlvorrichtung (1) nach Anspruch 1, wobei die erste Kühlkörperoberfläche (10) im Bereich der Nutaussparung (6) eine aufgeraute Oberflächenstruktur (13) aufweist und die ersten Fasern (9) der Wärmerohroberfläche (7) des Wärmerohrs (3) eine mechanische Verbindung mit der aufgerauten Oberflächenstruktur (13) der Kühlkörperoberfläche (10) des Kühlkörpers (4) im Bereich der Nutaussparung (6) ausbilden.

5. Kühlvorrichtung (1) nach Anspruch 1, wobei die ersten Fasern (9) der Wärmerohroberfläche (7) des Wärmerohrs (3) die Kühlkörperoberfläche (10) des Kühlkörpers (4) im Bereich der Nutaussparung (6) durchdringen.

6. Kühlvorrichtung (1) nach einem der vorhergehenden Ansprüche, wobei die ersten Fasern (9) der Faserstruktur und, falls vorhanden, die zweiten Fasern (12) der weiteren Faserstruktur oder die aufgeraute Oberflächenstruktur (13) eine nanoskalige oder mikroskalige Struktur aufweisen.

7. Kühlvorrichtung (1) nach einem der vorhergehenden Ansprüche, wobei die ersten Fasern (9) Widerhaken (14) und, falls vorhanden, die zweiten Fasern (12) Ösen (15) aufweisen.

8. Kühlvorrichtung (1) nach einem der vorhergehenden Ansprüche, wobei die ersten Fasern (9) und, falls vorhanden, die zweiten Fasern (12) durch Materialbeschichtung oder durch Materialabtrag ausgebildet sind.

9. Kühlvorrichtung (1) nach einem der vorhergehenden Ansprüche, wobei ersten Fasern (9) der Wärmerohroberfläche (7) des Wärmerohrs (3) und, falls vorhanden, die zweiten Fasern (12) der Kühlkörperoberfläche (10) des Kühlkörpers (4) aus Kupfer oder aus einer Kupferlegierungen bestehen.

10. Kühlvorrichtung (1) nach einem der vorhergehenden Ansprüche, wobei das Material der ersten Fasern (9) des Wärmerohrs (3) mechanisch härter ist als das Material der Kühlkörperoberfläche (10) des Kühlkörpers (4).

11. Kühlvorrichtung (1) nach einem der vorhergehenden Ansprüche, wobei das Wärmerohr (3) eine Heatpipe ist.

12. Kühlvorrichtung (1) nach einem der vorhergehenden Ansprüche, wobei der Kühlkörper (4) an einer von der ersten Kühlkörperseite (5) abgewandten zweiten Kühlkörperseite (19) Kühlkörperrippen (20) aufweist.

13. Umrichter (16) zum Betrieb einer elektrischen Maschine (17) an einem elektrischen Netz (18) mit einer Kühlvorrichtung (1) nach einem der Ansprüche 1 bis 12 und einem elektronischen Bauelement (2), wobei das elektronische Bauelement (2) mit einem Kühlkörper (4) der Kühlvorrichtung (1) im Bereich eines von dem Kühlkörper (4) zumindest teilweise umschlossenen Wärmerohrs (3) der Kühlvorrichtung (1) mechanisch verbunden ist.

14. Umrichter (16) nach Anspruch 13, wobei der Kühlkörper (4) als Umrichtergehäuse oder als Teil eines Umrichtergehäuses ausgebildet ist.

15. Umrichter (16) nach Anspruch 13 oder 14, wobei das elektronische Bauelement (2) ein Leistungshalbleiter oder ein Leistungshalbleitermodul ist.
